# EUROPEAN PATENT APPLICATION

(11) **EP 2 244 540 A1**
(43) Date of publication of application: **27.10.2010**
(21) Application number: 10160473.4
(22) Date of filing: 20.04.2010
(51) Int. Cl.: H05K 3/28, G11C 5/00

(54) **Electronic devices with light source**

(30) Priority: 20.04.2009 IN CH08992009; 22.04.2009 IN CH09362009; 29.04.2009 IN CH09982009
(71) Applicant: Moser Baer India Limited, New Delhi 110020 (IN)
(72) Inventor: Singh, Jitender Pratap, 110020, New Delhi (IN); Malhi, Vijay, 110020, New Delhi (IN)
(74) Representative: Roche, Dermot

(57) **Abstract**

An electronic device with a light source is provided. The electronic device includes a base substrate (102), one or more electrical components (104) placed on the base substrate (102), and a light source (106) placed on the base substrate (102). The electrical components (104) and the light source (106) are electrically connected in a pre-defined manner. A molding material (108) is molded over the electrical components (104) and the light source (106), wherein the light source (106) is partially visible.

## Description

### CROSS-REFERENCE TO RELATED APPLICATIONS

This application claims priority from Indian Patent Application No. 998/CHE/2009 filed on April 29, 2009, Indian Patent Application No. 936/CHE/2009 filed on April 22, 2009, and Indian Patent Application No. 899/CHE/2009 filed on April 20, 2009. The entire disclosure of the prior applications is incorporated herein in their entirety by reference.

### BACKGROUND OF THE INVENTION

The present invention relates, in general, to electronic devices. More particularly, the present invention relates to a method of manufacturing an electronic device with a light source.

Universal Serial Bus (USB) flash drives are more common these days than any other portable storage devices. A USB flash drive is typically manufactured using Surface Mount Technology (SMT) in which a flash Integrated Circuit (IC) and other supporting electrical components are mounted on a Printed Circuit Board (PCB). Various components of the USB flash drive are then encapsulated using conventional encapsulation techniques. However, conventional encapsulation techniques often encapsulate various components of the USB flash drive in a non-hermetic seal. This may lead to loss of data when moisture or water comes in contact with the USB flash drive. The data may also be lost due to rough handling of the USB flash drive. This makes such USB flash drives unsuitable for storing important data reliably. Additionally, conventional USB flash drives are larger in size, which adds to inconvenience of end users. Whenever an attempt to miniaturize a USB flash drive is made, light indicators are sacrificed due to inherent complexity of the process of manufacturing miniaturized USB flash drives, as well as to reduce size. A light indicator typically indicates whether the USB flash drive is functioning properly, whether data is being accessed or not, etc. Removal of the light indicator causes inconvenience to the end users, who remain unaware of the state of the USB flash drive.

In light of the foregoing discussion, there is a need for a storage device that is highly reliable, shock resistant, water resistant and robust, compared to conventional storage devices. In addition, the storage device should be miniature in size to provide ease of handling and use. Further, a light indicator should also be incorporated in the storage device for convenience of end users.

### SUMMARY OF THE INVENTION

An object of the present invention is to provide an electronic device with a light source (and manufacturing methods and systems thereof).

Another object of the present invention is to provide a storage device that is highly reliable, shock resistant, water resistant and robust, compared to conventional storage devices.

Yet another object of the present invention is to provide a storage device that is miniature in size, and is easy to handle and use, compared to conventional storage devices.

Embodiments of the present invention provide an electronic device that includes a base substrate, one or more electrical components placed on the base substrate, and at least one light source placed on the base substrate. In accordance with an embodiment of the present invention, the electrical components and the light source are placed on the same surface of the base substrate.

A molding material is molded over the electrical components and the light source, wherein the light source is partially visible. In accordance with an embodiment of the present invention, the molding material is molded over a surface of the base substrate on which the electrical components and the light source are placed. The molding material encapsulates the electrical components and the light source hermetically. This makes the electronic device highly reliable, shock resistant, water resistant and robust.

The light source is connected to at least one of the electrical components. In accordance with an embodiment of the present invention, the light source is capable of indicating a pre-defined state of the electronic device. The pre-defined state may, for example, include at least one of: the electronic device being connected to a Universal Serial Bus (USB), the electronic device performing data read and/or write, or an occurrence of an error. The light source may, for example, include at least one Light-Emitting Diode (LED).

In accordance with an embodiment of the present invention, the light source is placed at a preset location on the base substrate. For example, the light source may be located at a periphery associated with the base substrate.

In an embodiment of the present invention, the electronic device is a storage device, and at least one of the electrical components is capable of storing data.

In an embodiment of the present invention, the electronic device is a Chip-On-Board (COB) type device. In another embodiment of the present invention, the electronic device is a Surface Mount Technology (SMT) type device.

In one embodiment of the present invention, a COB type storage device is manufactured by a COB process. As the COB process requires less space, a base substrate of a small size may be used. The COB type storage device so manufactured is miniature in size, and therefore, is easy to handle and use.

### BRIEF DESCRIPTION OF DRAWINGS

Embodiments of the present invention will hereinafter be described in conjunction with the appended drawings provided to illustrate and not to limit the scope of the claims, wherein like designations denote like elements, and in which:
FIGs. 1A, 1B and 1C depict top, front and side views of an electronic device, in accordance with an embodiment of the present invention;
FIGs. 2A, 2B and 2C depict top, front and side views of the electronic device, in accordance with an embodiment of the present invention;
FIG. 3 depicts a system for manufacturing an electronic device, in accordance with an embodiment of the present invention;
FIG. 4 depicts a system for manufacturing an electronic device, in accordance with another embodiment of the present invention;
FIG. 5 depicts a method of manufacturing an electronic device, in accordance with an embodiment of the present invention;
FIG. 6 depicts a method of manufacturing an electronic device, in accordance with another embodiment of the present invention;
FIG. 7 depicts a system for manufacturing a Chip-On-Board (COB) type storage device, in accordance with an exemplary embodiment of the present invention; and
FIG. 8 depicts a method of manufacturing a COB type storage device, in accordance with an exemplary embodiment of the present invention.

The same reference numerals refer to the same parts throughout the various figures.

### DETAILED DESCRIPTION

As used in the specification and claims, the singular forms "a", "an" and "the" include plural references unless the context clearly dictates otherwise. For example, the term "a light source" may include a plurality of light sources unless the context clearly dictates otherwise.

Embodiments of the present invention provide a method of manufacturing an electronic device, and electronic devices manufactured thereof. In the description of the embodiments of the present invention, numerous specific details are provided, such as examples of components and/or mechanisms, to provide a thorough understanding of embodiments of the present invention. One skilled in the relevant art will recognize, however, that an embodiment of the present invention can be practiced without one or more of the specific details, or with other apparatus, systems, assemblies, methods, components, materials, parts, and/or the like. In other instances, well-known structures, materials, or operations are not specifically shown or described in detail to avoid obscuring aspects of embodiments of the present invention.

### GLOSSARY

Base substrate: A base substrate is a substrate that provides mechanical support. The base substrate may, for example, be an electronic substrate that provides electrical connectivity. Examples of the base substrate include, but are not limited to, Printed Circuit Boards (PCBs), hybrid microcircuits, and extended PCBs. An extended PCB is a PCB including one or more conductive strips capable of facilitating a Universal Serial Bus (USB) connection.

Slot: A slot is an electrically-conductive strip, formed over a base substrate, to facilitate placing of electrical components.

Embedded connector: An embedded connector is an electrically-conductive arrangement embedded in a base substrate.

Bond pad: A bond pad is a pad, made of an electrically-conductive material, formed over a base substrate. The bond pad provides an interface to connect electrical components to embedded connectors.

Electrical connector: An electrical connector is a thin wire made of an electrically-conductive material for electrically connecting two points.

Electrical component: An electrical component is a component of an electronic device, and is placed on appropriate slots on a base substrate to achieve the objective of the electronic device.

Light Source: A light source is a source of light. The light source may, for example, include at least one Light-Emitting Diode (LED). A light source may, for example, be used to indicate a current state of an electronic device, in accordance with an embodiment of the present invention.

Molding material: A molding material is a material that may be molded in any desired form. The molding material may, for example, include at least one of: epoxy resin, silicone, acrylic and polyurethane.

Chip-On-Board (COB) type device: A COB type device is an electronic device manufactured by a COB process. A COB process includes directly placing a bare semiconductor die on an electronic substrate, and electrically connecting the bare semiconductor die to appropriate bond pads on the electronic substrate.

Surface Mount Technology (SMT) type device: An SMT type device is an electronic device manufactured by an SMT process. An SMT process includes mounting an Integrated Circuit (IC) on an electronic substrate.

In accordance with an embodiment of the present invention, an electronic device includes a base substrate, one or more electrical components placed on the base substrate, and at least one light source placed on the base substrate. In accordance with an embodiment of the present invention, the electrical components and the light source are placed on the same surface of the base substrate. A molding material is molded over the electrical components and the light source, wherein the light source is partially visible.

The light source is connected to at least one of the electrical components. In accordance with an embodiment of the present invention, the light source is capable of indicating a pre-defined state of the electronic device. The pre-defined state may, for example, include at least one of: the electronic device being connected to a USB, the electronic device performing data read and/or write, or an occurrence of an error. The light source may, for example, include at least one LED.

In accordance with an embodiment of the present invention, a portion of the molding material molded around the light source is removed, such that the light source is uncovered at least partially. This facilitates transmission of light emitted from the light source.

In accordance with an embodiment of the present invention, a portion of the light source is cut across a pre-defined plane. This further enhances the transmission of light emitted from the light source.

In accordance with an embodiment of the present invention, the light source is placed at a preset location on the base substrate. For example, the light source may be located at a periphery associated with the base substrate.

In an embodiment of the present invention, the electronic device is a storage device, and at least one of the electrical components is capable of storing data.

In an embodiment of the present invention, the electronic device is a COB type device. In another embodiment of the present invention, the electronic device is an SMT type device.

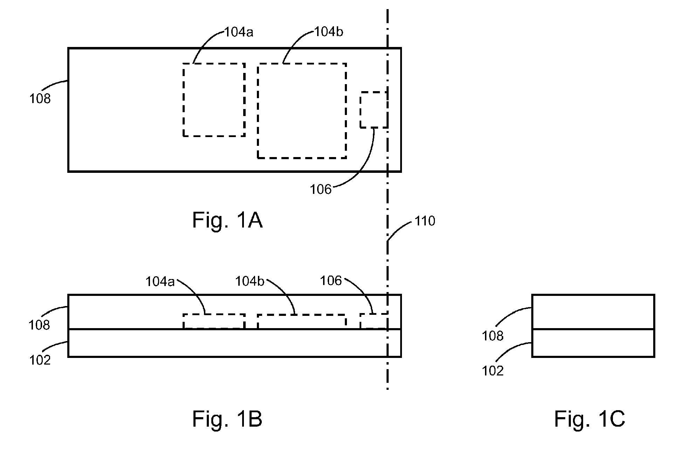

FIGs. 1A, 1B and 1C depict top, front and side views of an electronic device, in accordance with an embodiment of the present invention. The electronic device includes a base substrate 102, one or more electrical components, shown as an electrical component 104a and an electrical component 104b, and a light source 106. Electrical component 104a and electrical component 104b are hereinafter referred as electrical components 104.

Base substrate 102 may include a plurality of slots (not shown) to facilitate placing of electrical components 104 and light source 106. In accordance with an embodiment of the present invention, electrical components 104 and light source 106 are placed on the same surface of base substrate 102. Base substrate 102 may also include one or more embedded connectors (not shown) for electrically connecting electrical components 104 and light source 106 in a pre-defined manner. Electrical components 104 and light source 106 may, for example, be thermally and electrically bonded to base substrate 102 using an electrically-conductive paste. In addition, electrical components 104 may be wire-bonded to preset bond pads on base substrate 102 using one or more electrical connectors.

The electronic device also includes a molding material 108 molded over electrical components 104 and light source 106. Molding material 108 encapsulates electrical components and light source 106, as shown in FIGS. 1A-1C. In accordance with an embodiment of the present invention, a portion of molding material 108 molded around light source 106 is removed. In accordance with an embodiment of the present invention, base substrate 102 and molding material 108 are cut across a plane represented by a line 110.

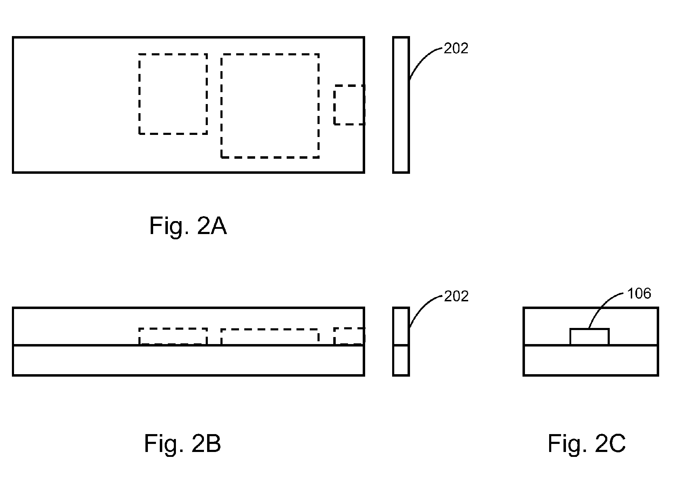

FIGs. 2A, 2B and 2C depict top, front and side views of the electronic device, after base substrate 102 and molding material 108 are cut, in accordance with an embodiment of the present invention. A portion 202 of base substrate 102 and molding material 108 is removed, such that light source 106 is uncovered at least partially, as shown. Consequently, light source 106 is partially visible. This facilitates transmission of light emitted from light source 106.

In accordance with an embodiment of the present invention, a portion of light source 106 is cut across a pre-defined plane, such that any traces of molding material 108 left over that portion of light source 106 are removed. This further enhances the transmission of light emitted from light source 106.

Light source 106 may, for example, include at least one LED. In accordance with an embodiment of the present invention, light source 106 is capable of indicating a pre-defined state of the electronic device. The pre-defined state may, for example, include at least one of: the electronic device being connected to a USB, the electronic device performing data read and/or write, or an occurrence of an error. For example, in case of a USB flash drive, light source 106 may indicate whether the USB flash drive is connected to a USB. In addition, light source 106 may indicate different states of the electronic device, for example, by emitting light of different colors, or by flickering. In an embodiment of the present invention, the electronic device is a storage device, and at least one of electrical components 104 is capable of storing data. In such a case, light source 106 may indicate whether the storage device is ready to be operated on.

In accordance with an embodiment of the present invention, light source 106 is placed at a preset location on base substrate 102. For example, light source 106 may be located at a periphery associated with base substrate 102, as shown.

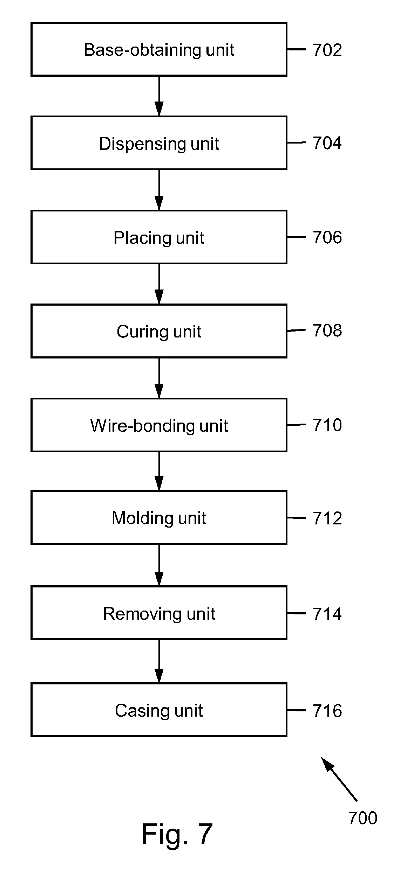

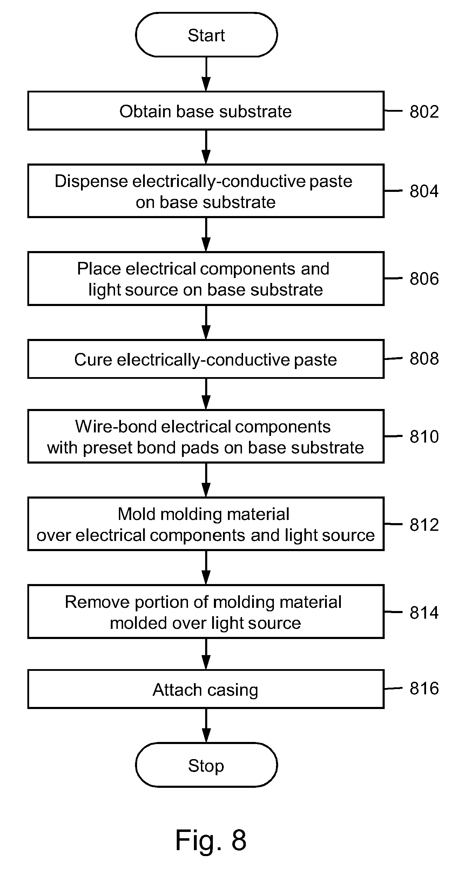

FIGs. 1A-1C and 2A-2C depict various stages in which an electronic device is manufactured, in accordance with an embodiment of the present invention. In accordance with an embodiment of the present invention, the electronic device is a COB type device. Consider, for example, that the electronic device is a storage device. In such a case, at least one of electrical components 104 may be a bare semiconductor die. Additionally, base substrate 102 may, for example, be an extended PCB that includes one or more conductive strips capable of facilitating a USB connection. Details of how a COB type device may be manufactured have been provided in conjunction with FIGs. 7 and 8.

In accordance with another embodiment of the present invention, the electronic device is an SMT type device. Consider, for example, that the electronic device is a storage device. In such a case, at least one of electrical components 104 may be a flash IC. In addition, a USB connector may be connected to base substrate 102.

It should be noted here that the electronic device so manufactured is not limited to a specific shape or size of its components. FIGs. 1A-1C and 2A-2C are merely an example, which should not unduly limit the scope of the claims herein. One of ordinary skill in the art would recognize many variations, alternatives, and modifications of embodiments of the present invention. For example, molding material 108 may be molded over more than one surface of base substrate 102. In accordance with an alternative embodiment of the present invention, only molding material 108 may be cut across the plane to uncover light source 106 partially.

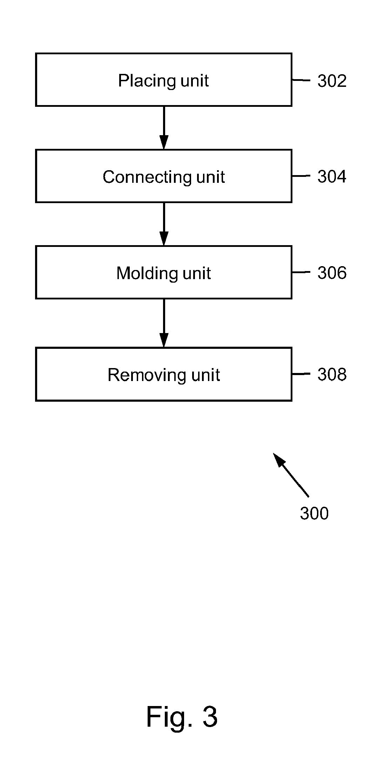

FIG. 3 depicts a system 300 for manufacturing an electronic device, in accordance with an embodiment of the present invention. System 300 includes a placing unit 302, a connecting unit 304, a molding unit 306 and a removing unit 308.

Placing unit 302 is adapted to place one or more electrical components and at least one light source on a base substrate. In accordance with an embodiment of the present invention, the electrical components and the light source are placed on the same surface of the base substrate. In accordance with another embodiment of the present invention, the electrical components and the light source are placed on different surfaces of the base substrate. The base substrate may include a plurality of slots to facilitate placing of the electrical components and the light source. Placing unit 302 may, for example, be a pick-and-place unit that is programmed to pick the electrical components and the light source and place them on appropriate slots on the base substrate.

The base substrate may also include one or more embedded connectors for electrically connecting the electrical components and the light source in a pre-defined manner. Connecting unit 304 may, for example, be adapted to thermally and electrically bond the electrical components and the light source to appropriate slots on the base substrate. In addition, connecting unit 304 may be adapted to wire-bond the electrical components to preset bond pads on the base substrate using one or more electrical connectors.

Molding unit 306 is adapted to mold a molding material over the electrical components and the light source, such that the molding material encapsulates the electrical components and the light source. Molding unit 306 may, for example, be a transfer molding machine adapted to mold the molding material over a surface of the base substrate on which the electrical components and the light source are placed. In an alternative embodiment of the present invention, the molding material may be molded over more than one surface of the base substrate.

Removing unit 308 is adapted to remove a portion of the molding material molded around the light source, such that the light source is uncovered at least partially. In an embodiment of the present invention, removing unit 308 includes a dicing saw that is programmed to mechanically cut through the molding material as desired. In another embodiment of the present invention, removing unit 308 includes a laser-cutting device that is programmed to remove the portion of the molding material as desired. Removing unit 308 may be automated and controlled by a work file that describes the location and the direction in which the cut is to be made.

As described above, the removal of the portion of the molding material molded around the light source facilitates transmission of light emitted from the light source. The light source uncovered at least partially is capable of indicating a pre-defined state of the electronic device, in accordance with an embodiment of the present invention. The pre-defined state may, for example, include at least one of: the electronic device being connected to a USB, the electronic device performing data read and/or write, or an occurrence of an error. In addition, the light source may indicate different states of the electronic device, for example, by emitting light of different colors, or by flickering. For example, in case of a USB flash drive, the light source may indicate whether the USB flash drive is connected to a USB.

In an embodiment of the present invention, the electronic device is a storage device, and at least one of the electrical components is capable of storing data. In such a case, the light source may indicate whether the storage device is ready to be operated on.

FIG. 3 is merely an example, which should not unduly limit the scope of the claims herein. One of ordinary skill in the art would recognize many variations, alternatives, and modifications of embodiments of the present invention. For example, system 300 may include a trace-removing unit adapted to remove any traces of the molding material left over the light source, so as to further enhance the transmission of light emitted from the light source.

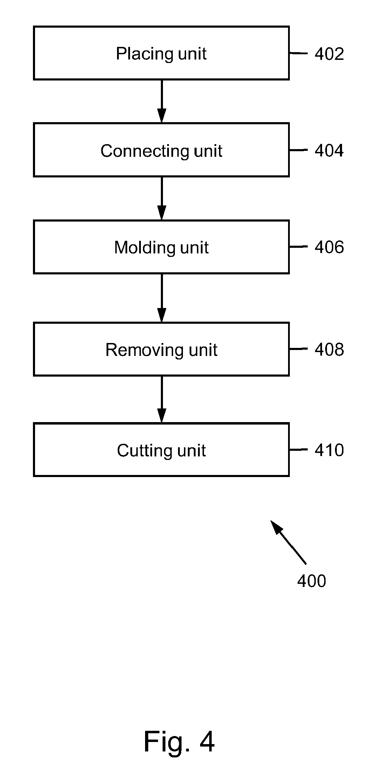

FIG. 4 depicts a system 400 for manufacturing an electronic device, in accordance with another embodiment of the present invention. System 400 includes a placing unit 402, a connecting unit 404, a molding unit 406, a removing unit 408 and a cutting unit 410.

Placing unit 402 is adapted to place one or more electrical components and at least one light source on a base substrate. In accordance with an embodiment of the present invention, the electrical components and the light source are placed on the same surface of the base substrate. In accordance with another embodiment of the present invention, the electrical components and the light source are placed on different surfaces of the base substrate. The base substrate may include a plurality of slots to facilitate placing of the electrical components and the light source. Placing unit 402 may, for example, be a pick-and-place unit that is programmed to pick the electrical components and the light source, and place them on appropriate slots on the base substrate.

In accordance with an embodiment of the present invention, the light source is placed at a preset location on the base substrate. For example, the light source may be located at a periphery associated with the base substrate.

The base substrate may also include one or more embedded connectors for electrically connecting the electrical components and the light source in a pre-defined manner. Connecting unit 404 may, for example, be adapted to thermally and electrically bond the electrical components and the light source to appropriate slots on the base substrate. In addition, connecting unit 404 may be adapted to wire-bond the electrical components to preset bond pads on the base substrate using one or more electrical connectors.

Molding unit 406 is adapted to mold a molding material over the electrical components and the light source, such that the molding material encapsulates the electrical components and the light source. Molding unit 406 may, for example, be a transfer molding machine adapted to mold the molding material over a surface of the base substrate on which the electrical components and the light source are placed. In an alternative embodiment of the present invention, the molding material may be molded over more than one surface of the base substrate.

Removing unit 408 is adapted to remove a portion of the molding material molded around the light source, such that the light source is uncovered at least partially. In an embodiment of the present invention, removing unit 408 includes a dicing saw that is programmed to mechanically cut through the molding material as desired. In another embodiment of the present invention, removing unit 408 includes a laser-cutting device that is programmed to remove the portion of the molding material as desired. As mentioned above, removing unit 408 may be automated and controlled by a work file that describes the location and the direction in which the cut is to be made.

Cutting unit 410 is adapted to cut a portion of the light source across a pre-defined plane, such that any traces of the molding material left over that portion of the light source are removed. In an embodiment of the present invention, cutting unit 410 includes a dicing saw that is programmed to mechanically cut through the light source as desired. In another embodiment of the present invention, cutting unit 410 includes a laser-cutting device that is programmed to remove the portion of the light source as desired. As mentioned above, cutting unit 410 may be automated and controlled by a work file that describes the location and the direction in which the cut is to be made.

In an alternative embodiment of the present invention, removing unit 408 and cutting unit 410 are implemented together in the form of a dicing saw that is programmed to mechanically cut through the molding material and the light source as desired. In another alternative embodiment of the present invention, removing unit 408 and cutting unit 410 are implemented together in the form of a laser-cutting device that is programmed to remove the portion of the molding material and the portion of the light source as desired.

As described above, the removal of the portion of the molding material molded around the light source facilitates transmission of light emitted from the light source. In addition, the removal of the portion of the light source further enhances the transmission of light emitted from the light source. The light source so uncovered is capable of indicating a pre-defined state of the electronic device, in accordance with an embodiment of the present invention. The pre-defined state may, for example, include at least one of: the electronic device being connected to a USB, the electronic device performing data read and/or write, or an occurrence of an error. In addition, the light source may indicate different states of the electronic device, for example, by emitting light of different colors, or by flickering. For example, in case of a USB flash drive, the light source may indicate whether the USB flash drive is connected to a USB.

In an embodiment of the present invention, the electronic device is a storage device, and at least one of the electrical components is capable of storing data. In such a case, the light source may indicate whether the storage device is ready to be operated on.

FIG. 4 is merely an example, which should not unduly limit the scope of the claims herein. One of ordinary skill in the art would recognize many variations, alternatives, and modifications of embodiments of the present invention.

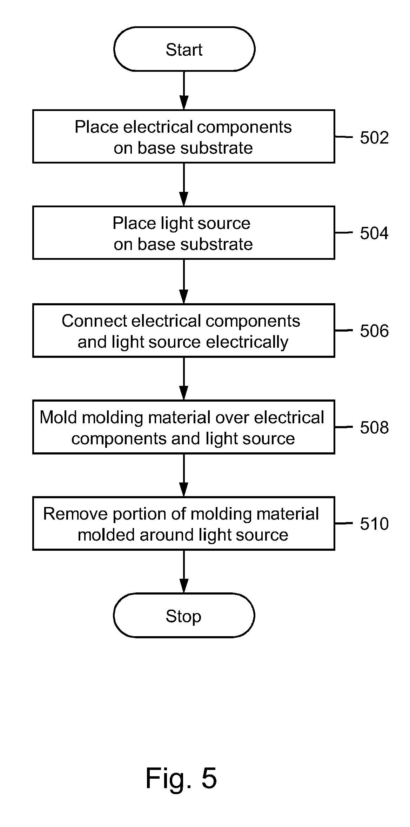

FIG. 5 depicts a method of manufacturing an electronic device, in accordance with an embodiment of the present invention. The method is illustrated as a collection of steps in a logical flow diagram, which represents a sequence of steps that can be implemented in hardware, software, or a combination thereof.

At step 502, one or more electrical components are placed on a base substrate. Step 502 may, for example, be performed by a pick-and-place unit that is programmed to pick the electrical components and place them on appropriate slots on the base substrate.

At step 504, at least one light source is placed on the base substrate. Step 504 may, for example, be performed by a pick-and-place unit that is programmed to pick the light source and place it on an appropriate slot on the base substrate.

At step 506, the electrical components and the light source are electrically connected in a pre-defined manner. For this purpose, the base substrate may, for example, include one or more embedded connectors. In accordance with step 506, the electrical components and the light source may be thermally and electrically bonded to appropriate slots on the base substrate. Additionally, the electrical components may be wire-bonded to preset bond pads on the base substrate using one or more electrical connectors.

At step 508, a molding material is molded over the electrical components and the light source, such that the molding material encapsulates the electrical components and the light source. Step 508 may, for example, be performed by a transfer molding machine adapted to mold the molding material over a surface of the base substrate on which the electrical components and the light source are placed. In an alternative embodiment of the present invention, the molding material may be molded over more than one surface of the base substrate.

At step 510, a portion of the molding material molded around the light source is removed, such that the light source is uncovered at least partially. In an embodiment of the present invention, step 510 includes sawing, using a dicing saw that is programmed to mechanically cut through the molding material as desired. In another embodiment of the present invention, step 510 includes laser cutting, using a laser-cutting device that is programmed to remove the portion of the molding material as desired. Step 510 may be automated and controlled by a work file that describes the location and the direction in which the cut is to be made.

As described above, the removal of the portion of the molding material molded around the light source facilitates transmission of light emitted from the light source. The light source uncovered at least partially is capable of indicating a pre-defined state of the electronic device, in accordance with an embodiment of the present invention. The pre-defined state may, for example, include at least one of: the electronic device being connected to a USB, the electronic device performing data read and/or write, or an occurrence of an error. In addition, the light source may indicate different states of the electronic device, for example, by emitting light of different colors, or by flickering. For example, in case of a USB flash drive, the light source may indicate whether the USB flash drive is connected to a USB.

In an embodiment of the present invention, the electronic device is a storage device, and at least one of the electrical components is capable of storing data. In such a case, the light source may indicate whether the storage device is ready to be operated on.

It should be noted here that steps 502-510 are only illustrative and other alternatives can also be provided where steps are added, one or more steps are removed, or one or more steps are provided in a different sequence without departing from the scope of the claims herein. For example, an additional step of cleaning any traces of the molding material left over the light source may be performed, so as to further enhance the transmission of light emitted from the light source. In another example, step 504 may be performed before step 502.

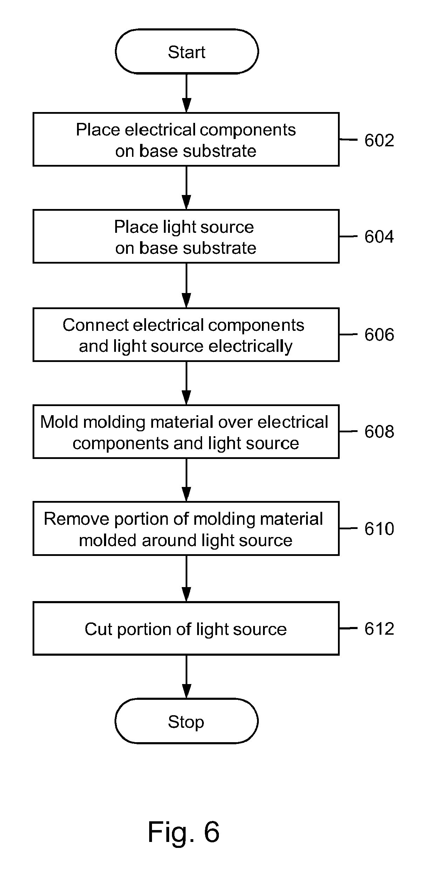

FIG. 6 depicts a method of manufacturing an electronic device, in accordance with another embodiment of the present invention. The method is illustrated as a collection of steps in a logical flow diagram, which represents a sequence of steps that can be implemented in hardware, software, or a combination thereof.

At step 602, one or more electrical components are placed on a base substrate. The base substrate may include one or more slots to facilitate placing of the electrical components. Step 602 may, for example, be performed by a pick-and-place unit that is programmed to pick the electrical components and place them on appropriate slots on the base substrate.

At step 604, at least one light source is placed on the base substrate. The base substrate may include a slot to facilitate placing of the light source. Step 604 may, for example, be performed by a pick-and-place unit that is programmed to pick the light source and place it on an appropriate slot on the base substrate.

In accordance with an embodiment of the present invention, the light source is placed at a preset location on the base substrate. For example, the light source may be located at a periphery associated with the base substrate.

At step 606, the electrical components and the light source are electrically connected in a pre-defined manner. For this purpose, the base substrate may, for example, include one or more embedded connectors. In accordance with step 606, the electrical components and the light source may be thermally and electrically bonded to appropriate slots on the base substrate. Additionally, the electrical components may be wire-bonded to preset bond pads on the base substrate using one or more electrical connectors.

At step 608, a molding material is molded over the electrical components and the light source, such that the molding material encapsulates the electrical components and the light source. Step 608 may, for example, be performed by a transfer molding machine adapted to mold the molding material over a surface of the base substrate on which the electrical components and the light source are placed. In an alternative embodiment of the present invention, the molding material may be molded over more than one surface of the base substrate.

At step 610, a portion of the molding material molded around the light source is removed, such that the light source is uncovered at least partially. In an embodiment of the present invention, step 610 includes sawing, using a dicing saw that is programmed to mechanically cut through the molding material as desired. In another embodiment of the present invention, step 610 includes laser cutting, using a laser-cutting device that is programmed to remove the portion of the molding material as desired. Step 610 may be automated and controlled by a work file that describes the location and the direction in which the cut is to be made.

At step 612, a portion of the light source is cut across a pre-defined plane, such that any traces of the molding material left over that portion of the light source are removed. In an embodiment of the present invention, step 612 includes sawing, using a dicing saw that is programmed to mechanically cut through the light source as desired. In another embodiment of the present invention, step 612 includes laser cutting, using a laser-cutting device that is programmed to remove the portion of the light source as desired. Step 610 may be automated and controlled by a work file that describes the location and the direction in which the cut is to be made.

In an alternative embodiment of the present invention, step 610 and step 612 are performed together by a dicing saw that is programmed to mechanically cut through the molding material and the light source as desired. In another alternative embodiment of the present invention, step 610 and step 612 are performed together by a laser-cutting device that is programmed to remove the portion of the molding material and the portion of the light source as desired.

As described above, the removal of the portion of the molding material molded around the light source facilitates transmission of light emitted from the light source. In addition, the removal of the portion of the light source further enhances the transmission of light emitted from the light source. The light source so uncovered is capable of indicating a pre-defined state of the electronic device, in accordance with an embodiment of the present invention. The pre-defined state may, for example, include at least one of: the electronic device being connected to a USB, the electronic device performing data read and/or write, or an occurrence of an error. In addition, the light source may indicate different states of the electronic device, for example, by emitting light of different colors, or by flickering. For example, in case of a USB flash drive, the light source may indicate whether the USB flash drive is connected to a USB.

In an embodiment of the present invention, the electronic device is a storage device, and at least one of the electrical components is capable of storing data. In such a case, the light source may indicate whether the storage device is ready to be operated on.

It should be noted here that steps 602-612 are only illustrative and other alternatives can also be provided where steps are added, one or more steps are removed, or one or more steps are provided in a different sequence without departing from the scope of the claims herein. For example, step 604 may be performed before step 602.

FIG. 7 depicts a system 700 for manufacturing a COB type storage device, in accordance with an exemplary embodiment of the present invention. System 700 includes a base-obtaining unit 702, a dispensing unit 704, a placing unit 706, a curing unit 708, a wire-bonding unit 710, a molding unit 712, a removing unit 714 and a casing unit 716.

Base-obtaining unit 702 is adapted to obtain a base substrate. The base substrate may include a plurality of slots to facilitate placing of electrical components and at least one light source. In accordance with an embodiment of the present invention, the electrical components and the light source are placed on the same surface of the base substrate. Accordingly, the base substrate may include the slots on the same surface. The base substrate may also include one or more embedded connectors for electrically connecting the electrical components and the light source placed on the slots in a pre-defined manner. The base substrate may, for example, be an extended PCB that includes one or more conductive strips capable of facilitating a USB connection.

Dispensing unit 704 is adapted to dispense an electrically-conductive paste on the slots on the base substrate. Dispensing unit 704 may, for example, include a stencil printer for printing the electrically-conductive paste on the slots.

Placing unit 706 is adapted to place one or more electrical components and at least one light source on appropriate slots on the base substrate, after the electrically-conductive paste is dispensed. In accordance with an embodiment of the present invention, at least one of the electrical components is capable of storing data. Placing unit 706 may, for example, be a pick-and-place unit that is programmed to pick the electrical components and the light source, and place them on appropriate slots on the base substrate.

In accordance with an embodiment of the present invention, the light source is placed at a preset location on the base substrate. For example, the light source may be located at a periphery associated with the base substrate.

Curing unit 708 is adapted to cure the electrically-conductive paste, after the electrical components and the light source are placed on the slots. Curing unit 708 may, for example, include an oven in which the base substrate with the placed electrical components and the placed light source may be heated to a preset temperature for a preset duration. Consequently, the electrical components and the light source are thermally and electrically bonded to their respective slots on the base substrate.

Wire-bonding unit 710 is adapted to wire-bond the electrical components with one or more preset bond pads on the base substrate using one or more electrical connectors. Wire-bonding unit 710 may, for example, implement thermo-sonic compression bonding using gold wires. In such a case, the base substrate is heated to a preset temperature to connect the gold wires to the electrical components and to the bond pads on the base substrate. In an additional embodiment of the present invention, system 700 includes a cleaning unit adapted to clean the bond pads on the base substrate, before wire-bonding. The cleaning unit may, for example, use plasma cleaning.

Molding unit 712 is adapted to mold the molding material over the electrical components and the light source, such that the molding material encapsulates the electrical components and the light source. Molding unit 712 may, for example, be a transfer molding machine adapted to mold the molding material over a surface of the base substrate on which the electrical components and the light source are placed. In an alternative embodiment of the present invention, the molding material may be molded over more than one surface of the base substrate.

Removing unit 714 is adapted to remove a portion of the molding material molded around the light source, such that the light source is uncovered at least partially. In an embodiment of the present invention, removing unit 714 includes a dicing saw that is programmed to mechanically cut through the molding material as desired. In another embodiment of the present invention, removing unit 714 includes a laser-cutting device that is programmed to remove the portion of the molding material as desired. As mentioned above, removing unit 714 may be automated and controlled by a work file that describes the location and the direction in which the cut is to be made.

In an additional embodiment of the present invention, removing unit 714 is also adapted to cut a portion of the light source across a pre-defined plane, such that any traces of the molding material left over that portion of the light source are removed.

In an alternative embodiment of the present invention, system 700 includes a cutting unit adapted to cut the portion of the light source across the pre-defined plane. In such a case, removing unit 714 may be used to remove the molding material, while the cutting unit may be used to cut the portion of the light source.

Casing unit 716 is adapted to attach a casing to the base substrate and/or the molded molding material. Casing unit 716 may, for example, implement a gluing process or an ultrasonic welding process.

As described above, the removal of the portion of the molding material molded around the light source facilitates transmission of light emitted from the light source. In addition, the removal of the portion of the light source further enhances the transmission of light emitted from the light source. The light source so uncovered is capable of indicating a pre-defined state of the electronic device, in accordance with an embodiment of the present invention. The pre-defined state may, for example, include at least one of: the storage device being connected to a USB, the storage device performing data read and/or write, or an occurrence of an error. In addition, the light source may indicate different states of the storage device, for example, by emitting light of different colors, or by flickering. For example, in case of a USB flash drive, the light source may indicate whether the USB flash drive is connected to a USB.

In an embodiment of the present invention, the electronic device is a storage device, and at least one of the electrical components is capable of storing data. In such a case, the light source may indicate whether the storage device is ready to be operated on.

FIG. 7 is merely an example, which should not unduly limit the scope of the claims herein. One of ordinary skill in the art would recognize many variations, alternatives, and modifications of embodiments of the present invention.

FIG. 8 depicts a method of manufacturing a COB type storage device, in accordance with an exemplary embodiment of the present invention. The method is illustrated as a collection of steps in a logical flow diagram, which represents a sequence of steps that can be implemented in hardware, software, or a combination thereof.

At step 802, a base substrate is obtained. The base substrate may include a plurality of slots to facilitate placing of electrical components and at least one light source. The base substrate may also include one or more embedded connectors for electrically connecting the electrical components and the light source placed on the slots in a pre-defined manner. The base substrate may, for example, be an extended PCB that includes one or more conductive strips capable of facilitating a USB connection.

At step 804, an electrically-conductive paste is dispensed on the slots on the base substrate. Thereafter, at step 806, one or more electrical components and at least one light source are placed on appropriate slots on the base substrate. Subsequently, at step 808, the electrically-conductive paste is cured, so as to thermally and electrically bond the electrical components and the light source to their respective slots on the base substrate.

Consider, for example, that a solder paste is dispensed on a slot on which an LED is to be placed, while a silver epoxy is dispensed on a slot on which a bare semiconductor die is to be placed. The solder paste and the silver epoxy are cured after the LED and the bare semiconductor die are placed.

At step 810, the bare semiconductor die is wire-bonded with one or more preset bond pads on the base substrate using one or more electrical connectors. Step 810 may, for example, be performed by thermo-sonic compression bonding using gold wires. In such a case, the base substrate is heated to a preset temperature to connect the gold wires to the bare semiconductor die and to the bond pads on the base substrate.

At step 812, a molding material, for example, an epoxy molding compound is molded over the LED, the bare semiconductor die and the gold wires, such that the epoxy molding compound encapsulates the LED, the bare semiconductor die and the gold wires. Step 812 may, for example, be performed by a transfer molding machine adapted to mold the epoxy molding compound over a surface of the base substrate on which the LED and the bare semiconductor die are placed.

At step 814, a portion of the epoxy molding compound molded around the LED is removed, such that the LED is uncovered at least partially. In an embodiment of the present invention, step 814 includes sawing, using a dicing saw that is programmed to mechanically cut through the epoxy molding compound as desired. In another embodiment of the present invention, step 814 includes laser cutting, using a laser-cutting device that is programmed to remove the portion of the epoxy molding compound as desired. As mentioned above, step 814 may be automated and controlled by a work file that describes the location and the direction in which the cut is to be made.

In an additional embodiment of the present invention, an additional step of cutting a portion of the LED across a pre-defined plane is performed. The pre-defined plane is defined such that any traces of the epoxy molding compound left over the portion of the LED are removed.

Finally, at step 816, a casing is attached to the base substrate and/or the molded epoxy molding compound. The casing may be attached, for example, through a gluing process or an ultrasonic welding process.

As described above, the removal of the portion of the epoxy molding compound molded around the LED facilitates transmission of light emitted from the LED. In addition, the removal of the portion of the LED further enhances the transmission of light emitted from the LED. The LED so uncovered is capable of indicating a pre-defined state of the electronic device, in accordance with an embodiment of the present invention. The pre-defined state may, for example, include at least one of: the storage device being connected to a USB, the storage device performing data read and/or write, or an occurrence of an error. In addition, the light source may indicate different states of the storage device, for example, by emitting light of different colors, or by flickering. For example, the LED may indicate whether the COB type storage device is ready to be operated on. In case of a USB flash drive, the LED may indicate whether the USB flash drive is connected to a USB.

It should be noted here that steps 802-816 are only illustrative and other alternatives can also be provided where steps are added, one or more steps are removed, or one or more steps are provided in a different sequences without departing from the scope of the claims herein. In accordance with an embodiment of the present invention, steps 802-814 may be performed on a panel including a plurality of base substrates. In such a case, an additional step of de-panelizing individual base substrates may be performed. The step of de-panelizing may, for example, be performed by a laser-cutting device.

Embodiments of the present invention provide a method of manufacturing an electronic device, and electronic devices manufactured thereof. In an embodiment of the present invention, the method may be suitably used in the manufacturing of an electronic device with a light source capable of indicating a pre-defined state of the electronic device.

The molding material encapsulates various components of the COB type storage device hermetically. This makes the COB type storage device highly reliable, shock resistant, water resistant and robust.

In one embodiment of the present invention, a COB type storage device is manufactured by a COB process. As the COB process requires less space, a base substrate of a small size may be used. The COB type storage device so manufactured is miniature in size. For example, the dimensions of the COB type storage device may be as follows: length ranging from 20 mm to 30 mm, width ranging from 10 mm to 15 mm, and height ranging from 1 mm to 2 mm. Such a miniaturized COB type storage device is easy to handle and use.

Consequently, the COB type storage device may be designed in several forms, due to its miniature size and robustness. In one example, the COB type storage device may be designed in the form of a small-sized chip that may be carried in a wallet. In another example, the COB type storage device may be designed in the form of a key ring that is easy to carry.

In addition, the storage capacity of the COB type storage device may be increased without changing the overall dimensions of its casing.

Moreover, the cost of manufacture is reduced, as small-sized base substrates and bare semiconductor dies are used.

This application may disclose several numerical range limitations that support any range within the disclosed numerical ranges even though a precise range limitation is not stated verbatim in the specification because the embodiments of the invention could be practiced throughout the disclosed numerical ranges. Finally, the entire disclosure of the patents and publications referred in this application, if any, are hereby incorporated herein in entirety by reference.

Therefore, the foregoing is considered as illustrative only of the principles of the invention. Further, since numerous modifications and changes will readily occur to those skilled in the art, it is not desired to limit the invention to the exact construction and operation shown and described, and accordingly, all suitable modifications and equivalents may be resorted to, falling within the scope of the invention.

## Claims

1. A storage device comprising:
a base substrate (102);
one or more electrical components (104) placed on said base substrate (102), at least one of said electrical components (104) being capable of storing data;
at least one light source (106) placed on said base substrate (102), said light source (106) being connected to at least one of said electrical components (104), said light source (106) being capable of indicating a pre-defined state of said storage device; and
a molding material (108) molded over said electrical components (104) and said light source (106), wherein said light source (106) is partially visible.

2. The storage device of claim 1, wherein said electrical components (104) and said light source (106) are placed on a same surface of said base substrate (102).

3. The storage device of claim 1, wherein said light source (106) is located at a periphery, said periphery being associated with said base substrate (102).

4. The storage device of claim 1 is a Chip-On-Board (COB) type device.

5. The storage device of claim 1 is a Surface Mount Technology (SMT) type device.

6. The storage device of claim 1 is a Universal Serial Bus (USB) flash drive.

7. The storage device of claim 1, wherein said molding material (108) is molded over a surface of said base substrate (102) on which said electrical components (104) and said light source (106) are placed.

8. The storage device of claim 1, wherein said pre-defined state comprises at least one of: said storage device being connected to a Universal Serial Bus (USB), said storage device performing data read and/or write, and an occurrence of an error.

9. An electronic device comprising:
a base substrate (102);
one or more electrical components (104) placed on said base substrate (102);
at least one light source (106) placed on said base substrate (102), said light source (106) being connected to at least one of said electrical components (104), said light source (106) being capable of indicating a pre-defined state of said electronic device; and
a molding material (108) molded over said electrical components (104) and said light source (106), wherein said light source (106) is partially visible.

10. The electronic device of claim 9, wherein said electrical components (104) and said light source (106) are placed on a same surface of said base substrate (102).

11. The electronic device of claim 9, wherein said light source (106) is located at a periphery, said periphery being associated with said base substrate (102).

12. The electronic device of claim 9 is a Chip-On-Board (COB) type device.

13. The electronic device of claim 9 is a Surface Mount Technology (SMT) type device.

14. The electronic device of claim 9 is a storage device, wherein at least one of said electrical components (104) is capable of storing data.

15. The electronic device of claim 9, wherein said molding material (108) is molded over a surface of said base substrate (102) on which said electrical components (104) and said light source (106) are placed.
